(19) Europäisches Patentamt
European Patent Office
Office européen des brevets

(11) **EP 4 068 629 A1**

(12) **EUROPEAN PATENT APPLICATION**

(43) Date of publication:
**05.10.2022 Bulletin 2022/40**

(21) Application number: **21165912.3**

(22) Date of filing: **30.03.2021**

(51) International Patent Classification (IPC):
***H03H 17/02*** (2006.01)     ***H03H 17/06*** (2006.01)
***H03H 21/00*** (2006.01)

(52) Cooperative Patent Classification (CPC):
**H03H 17/0273; H03H 17/0275; H03H 17/0282;**
**H03H 17/0657; H03H 21/0043;** H03H 2021/0056;
H03H 2021/0096

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Rohde & Schwarz GmbH & Co. KG**
**81671 München (DE)**

(72) Inventor: **Weikert, Oomke**
**81671 München (DE)**

(74) Representative: **Prinz & Partner mbB**
**Patent- und Rechtsanwälte**
**Rundfunkplatz 2**
**80335 München (DE)**

(54) **HIGH-PASS FILTER MODULE AND METHOD FOR DETERMINING FILTER COEFFICIENTS**

(57) A high-pass filter module (10) is described. The high-pass filter module (10) comprises a signal input (12), a signal output (14), and a polyphase filter (16). The polyphase filter (16) is connected to both the signal input (12) and the signal output (14). The signal input (12) is configured to receive an input signal that comprises a set of input signal samples. The polyphase filter (16) is configured to determine additional samples based on the input signal samples, thereby obtaining an output signal comprising an augmented set of input signal samples. Filter coefficients of the polyphase filter (16) depend on an inverse of an autocorrelation matrix of the input signal. Each element of the autocorrelation matrix comprises a respective weighting factor, wherein the weighting factors each comprise a sign-alternating factor, wherein the sign-altering factor alters its sign between neighboring input signal samples. Further, a method for determining filter coefficients of a high-pass filter module (10) is described.

Fig. 1

EP 4 068 629 A1

**Description**

The invention relates to a high-pass filter module. The invention further relates to a method for determining filter coefficients of a high-pass filter module.

Interpolation filters and resamplers are known in the state of the art and are used in a variety of different applications. In general, such interpolation filters and re-samplers are used in order to obtain sample points that lie between other sample points and/or in order to adapt the sample rate of an input signal.

For certain types of applications, interpolation filters or resamplers having a high-pass characteristic are needed. This can be achieved by determining the filter coefficients of the interpolation filter or of the resampler by sampling an impulse response of a time-continuous ideal high-pass filter.

However, it has turned out, that the achievable interpolation accuracy is not sufficient for high-precision applications if the filter coefficients are obtained in this way.

Thus, the object of the present invention is to provide a filter module having a high-pass characteristic and an enhanced interpolation accuracy.

According to the invention, the problem is solved by a high-pass filter module, comprising a signal input, a signal output, and a polyphase filter. The polyphase filter is connected to both the signal input and the signal output. The signal input is configured to receive an input signal that comprises a set of input signal samples. The polyphase filter is configured to determine additional samples based on the input signal samples, thereby obtaining an output signal comprising an augmented set of input signal samples. Filter coefficients of the polyphase filter depend on an inverse of an autocorrelation matrix of the input signal. Each element of the autocorrelation matrix comprises a respective weighting factor, wherein the weighting factors each comprise a sign-alternating factor, wherein the sign-altering factor alters its sign between neighboring input signal samples.

It has turned out that the sign-altering factor in the filter coefficients of the polyphase filter causes a high-pass characteristic of the high-pass filter module. At the same time, the filter coefficients of the polyphase filter can be chosen such that the additional samples are determined with a minimal interpolation error.

For example, the filter coefficients are obtained by minimizing a deviation of the output signal of the polyphase filter from an ideal output signal such that the interpolation error is minimized.

Thus, the invention provides a high-pass filter module having both a high-pass characteristic and a minimal interpolation error.

In general, the filter coefficients are applied by the polyphase filter when processing the input signal, thereby generating the output signal.

The high-pass filter module according to the invention may be used as an interpolation filter, as a resampler, or as a component of an interpolation filter or of a resampler.

Alternatively or additionally, the polyphase filter may be configured to compensate a time-shift, particularly a delay, of the input signal, e.g. with respect to another signal. Polyphase filters are particularly suitable for compensating time-shifts, particularly delays.

According to an aspect of the invention, the input signal is a bandlimited signal. Particularly, the input signal is limited to a (desired) pass-band of the high-pass filter module. It has turned out that aliasing effects are reduced if the input signal is bandlimited.

The input signal may have a lower threshold frequency and/or an upper threshold frequency that delimit the spectrum of the input signal.

Optionally, the high-pass filter module may comprise a pre-filter module, wherein the pre-filter is configured to confine the input signal to the (desired) pass-band of the high-pass filter module. For example, the pre-filter module may comprise a low-cut filter and/or a high-cut filter, such that portions of the input signal below the lower threshold frequency and/or above the upper threshold frequency are attenuated, or rather cut off.

According to another aspect of the invention, the sign-altering factor is $e^{j\pi n}$, wherein $n$ is an integer numbering the input signal samples. The complex exponential is equal to 1 for $n = 0$ and for all even whole numbers, and is equal to -1 for all odd whole numbers. Accordingly, the sign-altering factor switches back and forth between -1 and 1 for neighboring input signal samples.

In an embodiment of the invention, the weighting factor depends on a cutoff-frequency of the polyphase filter. In general, the cutoff-frequency of the polyphase filter describes a lower boundary at which the frequency response of the polyphase filter quickly approaches zero. In other words, the cutoff frequency determines the high-pass characteristics of the polyphase filter and thus of the high-pass filter module at least partially, namely the frequency at which the frequency response becomes zero. The cutoff-frequency may be adaptable in order to obtain desired high-pass characteristics of the high-pass filter module.

In a further embodiment of the invention, the weighting factor comprises a sinc function, wherein the argument of the sinc function depends on a cutoff-frequency of the polyphase filter. The sinc function is multiplied with the sign-alternating factor, particularly with the sign-altering factor $e^{j\pi n}$ described above.

According to a further aspect of the invention, the filter coefficients of the polyphase filter depend on a product of the inverse of the autocorrelation matrix with a cross-correlation vector. In other words, the filter coefficient of the polyphase filter can (up to a pre-factor) be determined by calculating the autocorrelation matrix of the input signal, inverting the autocorrelation matrix, and multiplying the inverted autocorrelation matrix with the cross-correlation vector from the right-hand side.

Particularly, the cross-correlation vector is associated with a correlation of the input signal with an ideal output signal. In other words, the cross-correlation vector is an expectation value of the input signal multiplied with the ideal output signal. Within the expectation value, samples associated with the ideal output signal may be shifted in time by an integer fraction of the inverse sampling frequency.

According to an aspect of the invention, the filter coefficients of the polyphase filter depend on a Lagrange parameter, wherein the Lagrange parameter is associated with a side-condition, particularly wherein the side-condition relates to the output signal being unbiased. In other words, the filter coefficients of the polyphase filter may be obtained by minimizing the deviation of the output signal from the ideal output signal under the side-condition using the method of Lagrange parameters.

In an embodiment of the invention, the Lagrange parameter depends on an expectation value of a square of an ideal output signal, on the inverse of the autocorrelation matrix, and on a cross-correlation vector.

According to the invention, the problem further is solved by a method for determining filter coefficients of a high-pass filter module, particularly of a high-pass filter module as described above. The method comprises the following steps:

- receiving an input signal, wherein the input signal comprises a set of input signal samples;

- determining an autocorrelation matrix based on the input signal, wherein each element of the autocorrelation matrix comprises a respective weighting factor, wherein the weighting factors each comprise a sign-alternating factor, and wherein the sign-altering factor alters its sign between neighboring input signal samples; and

- determining filter coefficients of a polyphase filter based on the determined autocorrelation matrix, wherein the filter coefficients of the polyphase filter depend on an inverse of an autocorrelation matrix.

Regarding the advantages of the method, reference is made to the explanations given above with respect to the high-pass filter module, which also hold for the method and vice versa.

According to an aspect of the invention, the input signal is a bandlimited signal. Particularly, the input signal is limited to a (desired) pass-band of the high-pass filter module. It has turned out that aliasing effects are reduced if the input signal is bandlimited.

The input signal may have a lower threshold frequency and/or an upper threshold frequency that delimit the spectrum of the input signal.

Optionally, the high-pass filter module may comprise a pre-filter module. The input signal may be filtered by means of the pre-filter module in order to confine the input signal to the (desired) pass-band of the high-pass filter module. For example, the pre-filter module may comprise a low-cut filter and/or a high-cut filter, such that portions of the input signal below the lower threshold frequency and/or above the upper threshold frequency are attenuated, or rather cut off.

According to another aspect of the invention, the filter coefficients are determined by minimizing a deviation of an output signal of the polyphase filter from an ideal output signal, particularly via a least mean squares technique. This way, the interpolation error for determining the additional signal samples is reduced to a minimum.

The deviation may be minimized under a side-condition, particularly wherein the side-condition relates to the output signal being unbiased. In other words, the filter coefficients of the polyphase filter may be obtained by minimizing the deviation of the output signal from the ideal output signal under the side-condition, e.g. using the method of Lagrange parameters.

In a further embodiment of the invention, the filter coefficients of the polyphase filter are determined by calculating a product of the inverse of the autocorrelation matrix with a cross-correlation vector. Thus, the filter coefficient of the polyphase filter can (up to a pre-factor) be determined by calculating the autocorrelation matrix of the input signal, inverting the autocorrelation matrix, and multiplying the inverted autocorrelation matrix with the cross-correlation vector from the right-hand side.

According to another aspect of the invention, the cross-correlation vector is determined by calculating a correlation of the input signal with an ideal output signal. The cross-correlation vector is an expectation value of the input signal multiplied with the ideal output signal. Within the expectation value, samples associated with the ideal output signal may be shifted in time by an integer fraction of the inverse sampling frequency.

The foregoing aspects and many of the attendant advantages of the claimed subject matter will become more readily appreciated as the same become better understood by reference to the following detailed description, when taken in conjunction with the accompanying drawings, wherein:

- Figure 1 schematically shows a high-pass filter module according to the invention;

- Figure 2 shows a flowchart of a method for determining filter coefficients of the high-pass filter module of Figure 1 according to the invention;

- Figure 3 shows a first set of diagrams illustrating properties of a high-pass filter module according to the state of the art;

- Figure 4 shows a set of diagrams corresponding to the diagrams of Figure 3, illustrating properties of a high-pass filter module according to the invention;

- Figure 5 shows a second set of diagrams illustrating properties of a high-pass filter module according to the state of the art; and

- Figure 6 shows a set of diagrams corresponding to the diagrams of Figure 5, illustrating properties of a high-pass filter module according to the invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

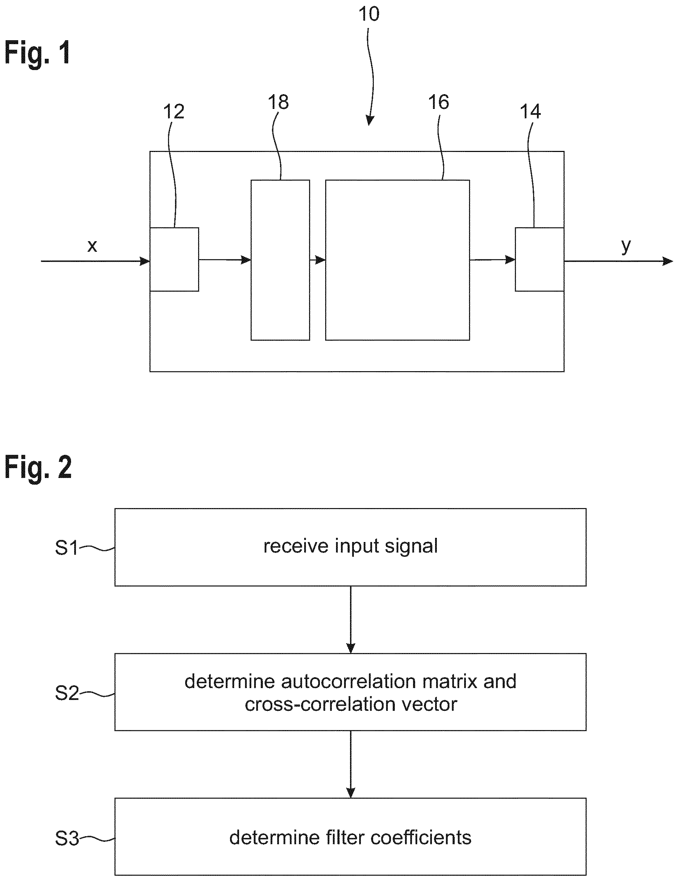

Figure 1 shows a block diagram of a high-pass filter module 10.

Therein and in the following, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry.

The high-pass filter module 10 comprises a signal input 12, a signal output 14, and a polyphase filter 16.

Optionally, the high-pass filter module 10 may comprise a pre-filter module 18 that is interconnected between the signal input 12 and the polyphase filter 16.

The signal input 12 is configured to receive an input signal x. The input signal x comprises a set of input signal samples $x(n)$, wherein $n$ is an integer numbering the individual input signal samples.

In time domain, the individual samples of the set of input signal samples are spaced apart by the sample time $t_{al}$, wherein the sample time $t_{al}$ is the inverse of a sampling frequency $f_{al}$ associated with the input signal.

The optional pre-filter module 18 is configured to confine the input signal x to a desired pass-band of the high-pass filter module 10. For example, the pre-filter module 18 may comprise a high-cut filter and/or a low-cut filter that are configured to filter the input signal $x$ in order to confine the input signal $x$ to the desired pass-band of the high-pass filter module 10.

The polyphase filter 16 is configured to determine additional samples based on the set of input signal samples, thereby obtaining an output signal y that comprises an augmented set of inputs signal samples.

More precisely, the polyphase filter 16 is configured to determine additional samples $y(n + \alpha)$, wherein $0 \le \alpha < 1$.

The parameter $\alpha = m/K$ can take $K$ different values, wherein m is an integer bigger than or equal to zero and smaller than $K$, and $K$ is an integer bigger than zero.

Accordingly, the polyphase filter 16 may determine $K$ additional signal samples (which are also called polyphases) between each pair of neighboring input signal samples $x(n)$ and $x(n + 1)$.

The filter coefficients $h_m$ associated with each polyphase m are a subset of all filter coefficients $h_{PPF}$ of the polyphase filter 16. The filter coefficients $h_m$ are defined as

$$h_m(r) = h_{PPF}(m + Kr).$$

(E.1)

The output signal *y* of the polyphase m of the polyphase filter 16 can then be written as

$$y(n + \alpha) = \sum_{r=0}^{N-1} h_m(r) \cdot x(n - r + N/2)$$

(E.2)

Accordingly, N/2 input signal samples to the left and to the right of the value to be interpolated are used for the interpolation of the value $y(n + \alpha)$.

Equation (E.2) can be rewritten as

$$y(n + \alpha) = h^T \cdot x,$$

(E.3)

with

$$x = [x(n + N/2), \; x(n - 1 + N/2), \; \ldots, \; x(n - (N-1) + N/2)]^T$$

(E.4)

and

$$h = [h_m(0), \; h_m(1), \; \ldots, \; h_m(N-1)]^T$$

(E.5)

The specific functional form of the filter coefficients $h_m$ will be explained in more detail below.

The signal output 16 is configured to receive the output signal y from the polyphase filter 16 and to output the output signal y.

In the following, a method for determining filter coefficients for the high-pass filter module 10 is described with reference to Figure 2.

The input signal *x* is received via the signal input 12 (step S1).

Optionally, the input signal *x* is filtered by means of the pre-filter module 18, such that the input signal *x* is confined to the desired pass-band of the high-pass filter module 10.

For the determination of the filter coefficients *h*, it is assumed that the input signal *x* is a bandlimited signal having the following z-transform $X_{HP}(z = e^{j \cdot 2 \cdot \pi f})$:

$$X_{HP}(e^{j \cdot 2 \cdot \pi \cdot f}) = \begin{cases} 0 & \text{for } f \in \left[0, f_{gHP}/f_{aI}\right] \\ 1 & \text{for } f \in \left[f_{gHP}/f_{aI}, 1\right] \end{cases}$$

Therein, *f* is a normalized frequency, i.e. the actual frequency divided by the sample rate $f_{aI}$, $f_{gHP}$ is a cutoff frequency below which the z-transform of the input signal is zero.

The z-transform of the input signal can be expressed in terms of a z-transform of an ideal bandlimited low-pass signal:

$$X_{HP}\left(e^{j\cdot 2\cdot \pi\cdot f}\right) = X_{TP}\left(e^{j\cdot 2\cdot \pi\cdot \left(f-\frac{f_{al}}{2}\right)}\right),$$

with

$$X_{TP}(e^{j\cdot 2\cdot \pi\cdot f}) = \begin{cases} 1 & \text{for } f \in \left[0, f_{gTP}/f_{al}\right] \\ 0 & \text{for } f \in \left[f_{gTP}/f_{al}, 1\right] \end{cases},$$

and

$$f_{gTP}/f_{al} = 0.5 - f_{gHP}/f_{al}$$

(E.6)

Every input signal $x(n)$ that is bandlimited to the pass-band of the high-pass filter module 10 can be multiplied with the z-transform $X_{HP}(e^{j\cdot 2\cdot \pi f})$ without being changed, i.e. it holds $X(e^{j\cdot 2\cdot \pi f}) = X(e^{j\cdot 2\cdot \pi f}) \cdot X_{HP}(e^{j\cdot 2\cdot \pi f})$.

In general, the goal is to find filter coefficients $h_m(r)$ such that the resulting output signal $y(n + \alpha)$ deviates from an ideal output signal $y_{ideal}(n + \alpha)$ as little as possible.

Using a minimum-mean-square approach, the following functional $F$ has to be minimized in order to find the optimal filter coefficients $h_m(r)$:

$$F = E\{|y(n+\alpha) - y_{ideal}(n+\alpha)|^2\} = E\{|h^T \cdot x - y_{ideal}(n+\alpha)|^2\}.$$

(E.7)

The signals $x(n)$ and $y(n + \alpha)$ are purely real for integer $n$. With this property it follows:

$$\begin{aligned}
F &= E\{|y(n+\alpha) - y_{ideal}(n+\alpha)|^2\} \\
&= E\{|h^T \cdot x - y_{ideal}(n+\alpha)|^2\} \\
&= E\{(h^T \cdot x - y_{ideal}(n+\alpha)) \cdot (h^T \cdot x - y_{ideal}(n+\alpha))^*\} \\
&= E\{|h^T \cdot x|^2 - h^T \cdot x \cdot y^*_{ideal}(n+\alpha) - h^T \cdot x^* \cdot y_{ideal}(n+\alpha) + |y_{ideal}(n+\alpha)|^2\} \\
&= E\{|h^T \cdot x|^2 - h^T \cdot x \cdot y_{ideal}(n+\alpha) - h^T \cdot x \cdot y_{ideal}(n+\alpha) + |y_{ideal}(n+\alpha)|^2\} \\
&= E\{|h^T \cdot x|^2\} - 2 \cdot h^T E\{x \cdot y_{ideal}(n+\alpha)\} + E\{|y_{ideal}(n+\alpha)|^2\} \\
&= E\{(h^T \cdot x) \cdot (h^T \cdot x)^H\} - 2 \cdot h^T E\{x \cdot y_{ideal}(n+\alpha)\} + E\{|y_{ideal}(n+\alpha)|^2\} \\
&= E\{h^T \cdot x \cdot x^H \cdot h\} - 2 \cdot h^T E\{x \cdot y_{ideal}(n+\alpha)\} + E\{|y_{ideal}(n+\alpha)|^2\} \\
&= h^T \cdot \underbrace{E\{x \cdot x^H\}}_{=R} \cdot h - 2 \cdot h^T \underbrace{E\{x \cdot y_{ideal}(n+\alpha)\}}_{=p} + E\{|y_{ideal}(n+\alpha)|^2\}
\end{aligned}$$

(E.8)

Therein, a superscript H denotes transposition and complex conjugation. As the vector $h$ or rather its components are real, it follows that $h^H = h^T$.

R is the autocorrelation matrix of the input signal $x$. $p$ is a cross-correlation vector describing a correlation between the input signal x and the ideal output signal $y_{ideal}$.

The functional F becomes minimal if the filter coefficients take the following form:

$$h = 2 \cdot R^{-1} \cdot p$$

(E.9)

It is noted that this is the solution for the minimization without any additional side-conditions.

Therein, $R = E\{x \cdot x^H\}$ and $p = E\{x \cdot y_{ideal}(n + \alpha)\}$. The cross-correlation vector $p$ can be rewritten as

$$p = \left[ r_{xy}\left(\frac{N}{2}\right), \ldots, r_{xy}\left(-\frac{N}{2}+1\right) \right]^T$$ with $r_{xy}(l) = E\{x(n+l) \cdot y_{ideal}(n + \alpha)\}$.

The autocorrelation matrix $R$ of the input signal $x$ and the cross-correlation vector $p$ are determined (step S2).

The result for the autocorrelation matrix $R$ is

$$R = E\{ x \cdot x^H \}$$
$$= \begin{bmatrix} r_{xx}(0) & r_{xx}(1) & r_{xx}(2) & \ldots & r_{xx}(N-1) \\ r_{xx}(1) & r_{xx}(0) & r_{xx}(1) & \ldots & r_{xx}(N-2) \\ r_{xx}(2) & r_{xx}(1) & r_{xx}(0) & \ldots & r_{xx}(N-3) \\ \vdots & & & \ddots & \vdots \\ r_{xx}(N-1) & r_{xx}(N-2) & r_{xx}(N-3) & \ldots & r_{xx}(0) \end{bmatrix},$$

$$(E.10)$$

wherein $r_{xx}(m) = E\{x^*(n) \cdot x(n+m)\} = \frac{1}{N}\sum_n x^*(n) \cdot x(n+m).$ Therein, the assumption is used that the autocorrelation function $r_{xx}$ only depends on the time difference between two sample points, i.e.

$$r_{xx}(l - k) = E\{x^*(n + l) \cdot x(n + k)\} = E\{x^*(n) \cdot x(n + l - k)\}.$$

$$(E.11)$$

As x is purely real, the sum can be written as a convolution $x(-m) * x(m)$.

Accordingly, for the input signal $x_{HP}(n)$, the autocorrelation function $r_{xx}(m)$ can be calculated according to the following equation:

$$r_{xx}(m) = x_{HP}(-m) * x_{HP}(m) = \text{IDFT}\{X_{HP}(e^{+j\cdot 2\cdot\pi\cdot f}) \cdot X_{HP}(e^{+j\cdot 2\cdot\pi\cdot f})\}.$$

$$(E.12)$$

The result is

$$r_{xx}(m) = A \cdot e^{+j\cdot\pi\cdot m} \cdot \frac{sin(2 \cdot \pi \cdot f_{gTP}/f_{al} \cdot m)}{2 \cdot \pi \cdot f_{gTP}/f_{al} \cdot m}.$$

$$(E.13)$$

For the determination of the cross-correlation vector $p$, additional information on the ideal output signal $y_{ideal}$ is needed.

Based on the z-transforms $X_{TP}$ and $X_{HP}$ given in equation (E.6), the corresponding "time domain" signals $x_{TP}$ and $x_{HP}$ can be determined by means of an inverse discrete Fourier transform.

The result is

$$x_{TP}(n) = \text{IDFT}\{X_{TP}(e^{j\cdot 2\cdot\pi\cdot f})\} = A \cdot \frac{sin(2\cdot\pi\cdot f_{gTP}/f_{al}\cdot n)}{2\cdot\pi\cdot f_{gTP}/f_{al}\cdot n},$$

and

$$x_{HP}(n) = \text{IDFT}\{X_{HP}(e^{j \cdot 2 \cdot \pi \cdot f})\} = \text{IDFT}\{X_{TP}(e^{j \cdot 2 \cdot \pi(f - f_{al}/2)})\} = e^{+j \cdot \pi \cdot n} \cdot x_{TP}(n)$$

$$= A \cdot e^{+j \cdot \pi \cdot n} \cdot \frac{sin(2 \cdot \pi \cdot f_{gTP}/f_{al} \cdot n)}{2 \cdot \pi \cdot f_{gTP}/f_{al} \cdot n}.$$

$$(E.14)$$

Without restriction of generality, $A = 2 \cdot f_{gTP}/f_{al} = 2 \cdot (0.5 - f_{gHP}/f_{al})$.

The ideal output signal $y_{ideal}$ then follows from the requirement

$$y_{ideal,TP/HP}(n + \alpha) \equiv x_{TP/HP}(n + \alpha),$$

$$(E.15)$$

and thus

$$y_{ideal,TP}(n + \alpha) = x_{TP}(n + \alpha) = A \cdot \frac{sin(2 \cdot \pi \cdot f_{gTP}/f_{al} \cdot (n + \alpha))}{2 \cdot \pi \cdot f_{gTP}/f_{al} \cdot (n + \alpha)},$$

$$y_{ideal,HP}(n + \alpha) = e^{+j \cdot \pi \cdot n} \cdot x_{TP}(n + \alpha) = A \cdot e^{+j \cdot \pi \cdot n} \cdot \frac{sin(2 \cdot \pi \cdot f_{gTP}/f_{al} \cdot (n + \alpha))}{2 \cdot \pi \cdot f_{gTP}/f_{al} \cdot (n + \alpha)}$$

$$= A \cdot e^{+j \cdot \pi \cdot n} \cdot \frac{sin(2 \cdot \pi \cdot (0.5 - f_{gHP}/f_{al}) \cdot (n + \alpha))}{2 \cdot \pi \cdot (0.5 - f_{gHP}/f_{al}) \cdot (n + \alpha)}.$$

$$(E.16)$$

As the high-pass filter module 10 is supposed to have a high-pass characteristic, the ideal high-pass signal $y_{ideal,HP}$ is chosen, i.e. $y_{ideal} = y_{ideal,HP}$.

Based on the ideal output signal $y_{ideal}$, the cross-correlation terms $r_{xy}$ of the cross-correlation vector $p$ can be calculated as follows:

$$r_{xy}(l) = E\{ x_{HP}(n + l) \cdot y_{ideal,HP}(n + \alpha)\} = E\{ x_{HP}(n + l) \cdot e^{+j \cdot \pi \cdot n} \cdot x_{TP}(n + \alpha)\},$$

$$= E\{e^{+j \cdot \pi \cdot (n+l)} \cdot x_{TP}(n + l) \cdot e^{+j \cdot \pi \cdot n} \cdot x_{TP}(n + \alpha)\}$$

$$= e^{+j \cdot \pi \cdot l} \cdot E\{\underbrace{e^{+j \cdot 2 \cdot \pi \cdot n}}_{=1} \cdot x_{TP}(n + l) \cdot x_{TP}(n + \alpha)\}.$$

$$(E.17)$$

Under the assumption that the cross-correlation function $r_{xy}$ only depends on the time difference between two sample points, it follows

$$r_{xy}(l) = e^{+j \cdot \pi \cdot l} \cdot E\{ x_{TP}(n) \cdot x_{TP}(n + l - \alpha)\}$$

$$= e^{+j \cdot \pi \cdot l} \cdot \frac{1}{N} \sum_{n} x_{TP}(n) \cdot x_{TP}(n + l - \alpha)$$

$$= A \cdot e^{+j \cdot \pi \cdot l} \cdot \frac{sin(2 \cdot \pi \cdot f_{gTP}/f_{al} \cdot (l - \alpha))}{2 \cdot \pi \cdot f_{gTP}/f_{al} \cdot (l - \alpha)}.$$

$$(E.18)$$

The filter coefficients $h$ are determined based on the determined autocorrelation matrix $R$ and based on the determined cross-correlation vector $p$ (step S3).

Based on equations (E.10) and (E.13), the inverse autocorrelation matrix $R^{-1}$ is determined.

Then, the filter coefficients $h$ are calculated according to equation (E.9).

The explanations and results given above are obtained by minimizing the functional F of equation (E.7) without any further side-condition.

However, it is also possible to minimize the functional F under the constraint that the output signal $y$ shall be unbiased, i.e. that the expectation value of the output signal $y$ is the same as the expectation value of the ideal output signal $y_{ideal}$.

This constraint can be written as

$$E\left\{\frac{y(n+\alpha)}{y_{ideal}(n+\alpha)}\right\} = E\left\{\frac{h^T \cdot x}{y_{ideal}(n+\alpha)}\right\} \equiv 1.$$

(E.19)

This constraint can be rewritten as

$$h^T \cdot p \equiv E\left\{\left(y_{ideal}(n+\alpha)\right)^2\right\}.$$

(E.20)

This side-condition can be introduced into the functional $F$ using the method of Lagrange parameters, resulting in the following modified functional $F_\lambda$ that is to be minimized:

$$F_\lambda = \{|y(n+\alpha) - y_{ideal}(n+\alpha)|^2\} + \lambda \cdot \left(h^T \cdot p - E\left\{\left(y_{ideal}(n+\alpha)\right)^2\right\}\right),$$

(E.21)

wherein $\lambda$ is the Lagrange parameter. The filter coefficients $h$ minimizing the functional $F_\lambda$ are

$$h = \left(1 - \frac{\lambda}{2}\right) \cdot R^{-1} \cdot p,$$

(E.22)

with the Lagrange parameter $\lambda$ being defined by the equation

$$(1 - \lambda/2) = \frac{E\{(y_{ideal}(n+\alpha))^2\}}{p^T \cdot R^{-1} \cdot p}.$$

(E.23)

The result for the expectation value in the numerator of equation (E.23) is

$$E\{(y_{ideal}(n+\alpha))^2\} = \frac{1}{N}\sum_n y_{ideal}(n+\alpha) \cdot y_{ideal}(n+\alpha+0) = r_{yideal,yideal}(0),$$

(E.24)

wherein the autocorrelation function $r_{yideal,yideal}$ is defined as

$$r_{yideal,yideal}(l) = E\{y_{ideal}(n + \alpha) \cdot y_{ideal}(n + \alpha + l)\}$$

$$= \frac{1}{N} \sum_n y_{ideal}(n + \alpha) \cdot y_{ideal}(n + \alpha + l).$$

$$(E.25)$$

The autocorrelation function $r_{yideal,yideal}$ can be calculated explicitly as follows:

$$r_{yideal,yideal}(l)$$
$$= E\{y_{ideal,HP}(n + \alpha) \cdot y_{ideal,HP}(n + \alpha + l)\}$$
$$= \frac{1}{N} \sum_n y_{ideal,HP}(n + \alpha) \cdot y_{ideal,HP}(n + \alpha + l)$$
$$= \frac{1}{N} \sum_n e^{+j \cdot \pi \cdot n} \cdot x_{TP}(n + \alpha) \cdot e^{+j \cdot \pi \cdot (n+l)} \cdot x_{TP}(n + l + \alpha)$$
$$= \frac{1}{N} \cdot e^{+j \cdot \pi \cdot l} \cdot \sum_n \underbrace{e^{+j \cdot 2 \cdot \pi \cdot n}}_{=1} \cdot x_{TP}(n + \alpha) \cdot x_{TP}(n + l + \alpha)$$
$$= e^{+j \cdot \pi \cdot l} \cdot \left( x_{TP}(-l) * x_{TP}(l) \right)$$
$$= e^{+j \cdot \pi \cdot l} \cdot \left( x_{TP}(+l) * x_{TP}(l) \right)$$
$$= e^{+j \cdot \pi \cdot l} \cdot \text{IDFT}\{X_{TP}(e^{j \cdot 2 \cdot \pi \cdot f}) \cdot X_{TP}(e^{j \cdot 2 \cdot \pi \cdot f})\}$$
$$= e^{+j \cdot \pi \cdot l} \cdot \text{IDFT}\{X_{TP}(e^{j \cdot 2 \cdot \pi \cdot f})\}$$
$$= A \cdot e^{+j \cdot \pi \cdot l} \cdot \frac{sin(2 \cdot \pi \cdot f_{gTP}/f_{aI} \cdot l)}{2 \cdot \pi \cdot f_{gTP}/f_{aI} \cdot l)}.$$

$$(E.26)$$

Accordingly, the expectation value of equation (E.24) is

$$E\left\{ \left( y_{ideal,HP}(n + \alpha) \right)^2 \right\} = r_{yideal,yideal}(0) = A \cdot e^{+j \cdot \pi \cdot 0} \cdot \frac{sin(2 \cdot \pi \cdot f_{gTP}/f_{aI} \cdot 0)}{2 \cdot \pi \cdot f_{gTP}/f_{aI} \cdot 0)}.$$

$$(E.27)$$

Thus, all quantities necessary in order to calculate the filter coefficients $h$ according to equation (E.22) are provided.

It is important to note that the filter coefficients $h$ each comprise a sign-alternating factor $e^{j \cdot \pi n}$ that oscillates between -1 and 1 between each pair of neighboring input signal samples.

This sign-alternating factor causes the high-pass characteristic of the polyphase filter 16 and thus of the high-pass filter module 10.

At the same time, the deviation of the output signal $y$ from the ideal output signal $y_{ideal}$ is minimized by the filter coefficients $h$ according to equation (E.9) (without an additional side-condition) or according to equation (E.22) (with the additional side-condition).

Thus, the high-pass filter module 10 described above provides a minimal interpolation error while having a high-pass characteristic.

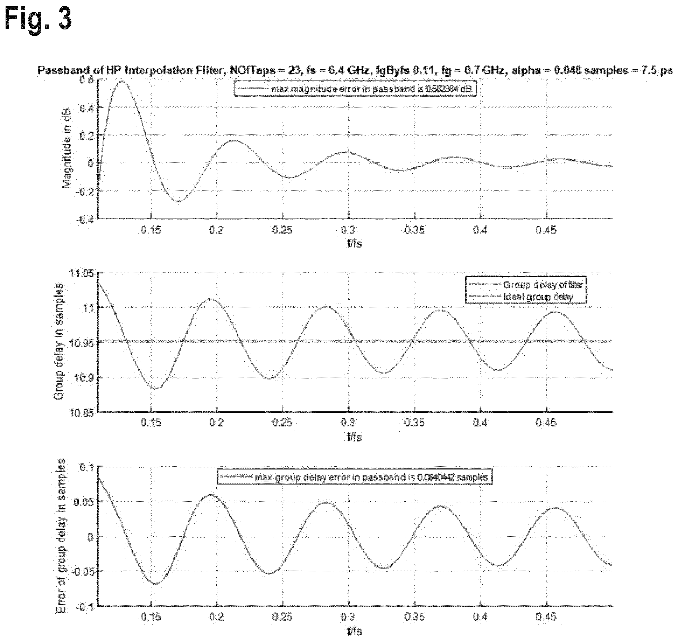

Figure 3 shows a set of diagrams illustrating properties of a high-pass interpolation filter according to the state of the art, wherein the filter coefficients of the high-pass interpolation filter are obtained by sampling an impulse response of a time-continuous ideal high-pass filter.

As can be seen in the top diagram in Figure 3, the maximum error is about 0.58 dB. As is shown in the lower diagram of Figure 3, the maximum group delay error is about 0.084 samples.

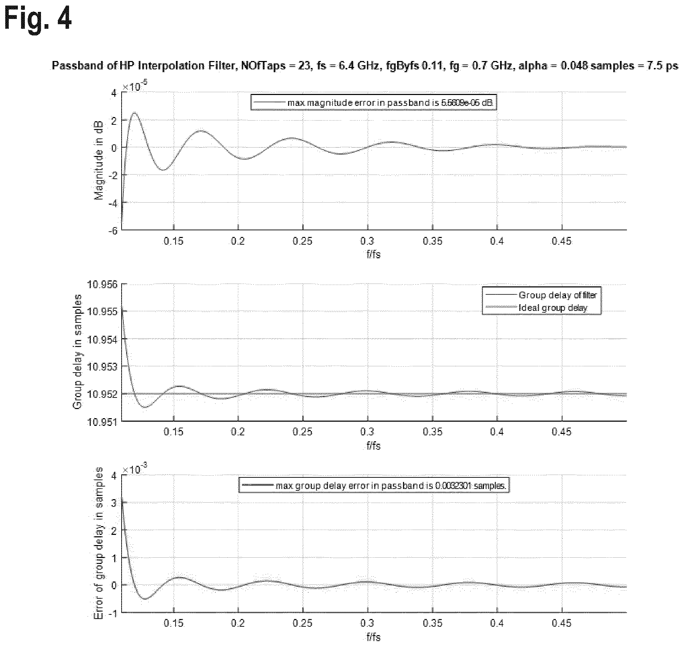

Figure 4 shows diagrams corresponding to the diagrams of Figure 3, but for the high-pass filter module 10 described above.

As is shown in the top diagram of Figure 4, the maximum error is about 5.56e-5 dB. Thus, compared to the state of the art, the interpolation error is reduced by a factor of about 10,000.

As is shown in the lower diagram of Figure 4, the maximum group delay error is about 0.0032 samples. Thus, compared to the state of the art, the maximum group delay error is reduced by a factor of about 26.

Moreover, as can be seen by a comparison of the middle diagrams of Figures 3 and 4, the group delay of the high-pass filter module 10 approaches the ideal group delay considerably quicker than the group delay of the high-pass interpolation filter according to the state of the art.

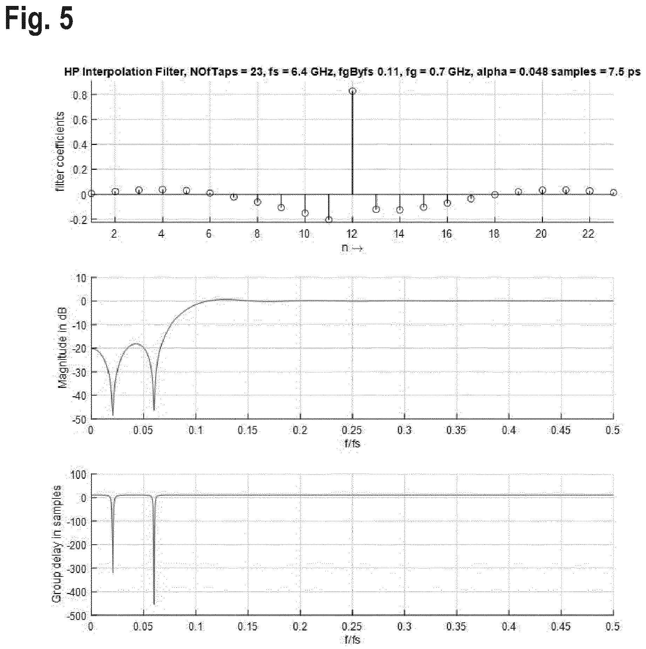

Figure 5 shows a second set of diagrams illustrating further properties of the high-pass interpolation filter according to the state of the art.

More precisely, the top diagram illustrates the filter coefficients of the high-pass interpolation filter. The middle diagram illustrates a frequency response of the high-pass interpolation filter, and the lower diagram illustrates a group delay of the high-pass interpolation filter.

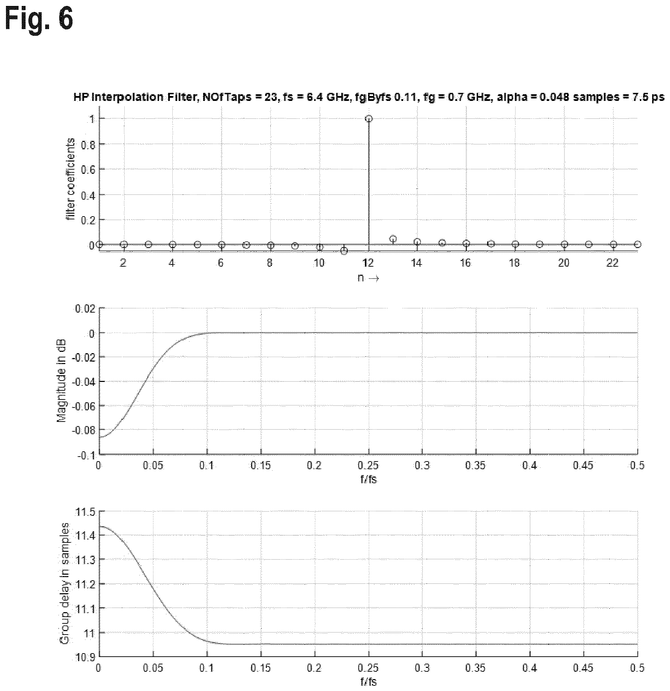

Figure 6 shows a set of diagrams corresponding to the diagrams of Figure 5, but for the high-pass filter module 10 described above.

As can be seen by a comparison of the middle diagrams of Figures 5 and 6, the frequency response of the high-pass filter module 10 exhibits a cleaner high-pass characteristic.

The frequency response of the high-pass interpolation filter according to the state of the art exhibits several dips or rather notches in the low-frequency range below 0.1 $f/f_s$, wherein $f_s$ is the sample rate, i.e. $f_s = f_{al}$.

The high-pass filter module 10, however, exhibits a steady decline in the low-frequency range below 0.1 $f/f_s$ (seen from right to left).

Certain embodiments disclosed herein, particularly the respective module(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

**Claims**

1. A high-pass filter module, comprising a signal input (12), a signal output (14), and a polyphase filter (16), wherein the polyphase filter (16) is connected to both the signal input (12) and the signal output (14),
   wherein the signal input (12) is configured to receive an input signal that comprises a set of input signal samples,
   wherein the polyphase filter (16) is configured to determine additional samples based on the input signal samples, thereby obtaining an output signal comprising an augmented set of input signal samples,
   wherein filter coefficients of the polyphase filter (16) depend on an inverse of an autocorrelation matrix of the input signal,
   wherein each element of the autocorrelation matrix comprises a respective weighting factor, wherein the weighting factors each comprise a sign-alternating factor, and
   wherein the sign-altering factor alters its sign between neighboring input signal samples.

2. The high-pass filter module according to claim 1, wherein the input signal is a bandlimited signal.

3. The high-pass filter module according to any of the preceding claims, wherein the sign-altering factor is $e^{j\pi n}$, wherein $n$ is an integer numbering the input signal samples.

4. The high-pass filter module according to any of the preceding claims, wherein the weighting factor depends on a cutoff-frequency of the polyphase filter (16).

5. The high-pass filter module according to any of the preceding claims, wherein the weighting factor comprises a sinc function, wherein the argument of the sinc function depends on a cutoff-frequency of the polyphase filter (16).

6. The high-pass filter module according to any of the preceding claims, wherein the filter coefficients of the polyphase filter (16) depend on a product of the inverse of the autocorrelation matrix with a cross-correlation vector.

7. The high-pass filter module according to claim 6, wherein the cross-correlation vector is associated with a correlation of the input signal with an ideal output signal.

8. The high-pass filter module according to any of the preceding claims, wherein the filter coefficients of the polyphase filter (16) depend on a Lagrange parameter, and wherein the Lagrange parameter is associated with a side-condition, particularly wherein the side-condition relates to the output signal being unbiased.

9. The high-pass filter module according to claim 8, wherein the Lagrange parameter depends on an expectation value of a square of an ideal output signal, on the inverse of the autocorrelation matrix, and on a cross-correlation vector.

10. A method for determining filter coefficients of a high-pass filter module (10), particularly of a high-pass filter module (10) according to any of the preceding claims, the method comprising the following steps:

   - receiving an input signal, wherein the input signal comprises a set of input signal samples;
   - determining an autocorrelation matrix based on the input signal, wherein each element of the autocorrelation matrix comprises a respective weighting factor, wherein the weighting factors each comprise a sign-alternating factor, and wherein the sign-altering factor alters its sign between neighboring input signal samples; and
   - determining filter coefficients of a polyphase filter (16) based on the determined autocorrelation matrix, wherein the filter coefficients of the polyphase filter depend on an inverse of an autocorrelation matrix.

11. The method according to claim 10, wherein the input signal is a bandlimited signal.

12. The method according to claim 10 or 11, wherein the filter coefficients are determined by minimizing a deviation of an output signal of the polyphase filter (16) from an ideal output signal, particularly via a least mean squares technique.

13. The method according to of claim 12, wherein the deviation is minimized under a side-condition, particularly wherein the side-condition relates to the output signal being unbiased.

14. The method according to any of the claims 10 to 13, wherein the filter coefficients of the polyphase filter (16) are determined by calculating a product of the inverse of the autocorrelation matrix with a cross-correlation vector.

15. The method of claim 14, wherein the cross-correlation vector is determined by calculating a correlation of the input signal with an ideal output signal.

**Fig. 1**

**Fig. 2**

S1 — receive input signal

S2 — determine autocorrelation matrix and cross-correlation vector

S3 — determine filter coefficients

# Fig. 3

Passband of HP Interpolation Filter, NOfTaps = 23, fs = 6.4 GHz, fgByfs 0.11, fg = 0.7 GHz, alpha = 0.048 samples = 7.5 ps

# Fig. 4

Passband of HP Interpolation Filter, NOfTaps = 23, fs = 6.4 GHz, fgByfs 0.11, fg = 0.7 GHz, alpha = 0.048 samples = 7.5 ps

# Fig. 5

HP Interpolation Filter, NOfTaps = 23, fs = 6.4 GHz, fgByfs 0.11, fg = 0.7 GHz, alpha = 0.048 samples = 7.5 ps

# Fig. 6

HP Interpolation Filter, NOfTaps = 23, fs = 6.4 GHz, fgByfs 0.11, fg = 0.7 GHz, alpha = 0.048 samples = 7.5 ps

Europäisches
Patentamt

European
Patent Office

Office européen
des brevets

# EUROPEAN SEARCH REPORT

Application Number

EP 21 16 5912

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/276284 A1 (JOHANSSON HAAKAN [SE]) 10 November 2011 (2011-11-10) * paragraphs [0106] - [0109]; figures 13, 14 * | 1-15 | INV. H03H17/02 H03H17/06 H03H21/00 |
| Y | Kyle Kastner: "Polyphase Filters and Filterbanks -Kyle Polyphase Filters and Filterbanks", , 19 March 2013 (2013-03-19), pages 1-9, XP055839683, Retrieved from the Internet: URL:https://www.dsprelated.com/showarticle /191.php [retrieved on 2021-09-09] * page 1 * | 1-15 | |
| Y | Lyons Richard G.: "HIGHPASS FIR FILTER DESIGN ¦ Chapter Five. Finite Impulse Response Filters" In: "Understanding digital signal processing", 1 January 2004 (2004-01-01), Prentice Hall Professional Technical Reference, Upper Saddle River, NJ, XP055839732, ISBN: 978-0-13-108989-1 pages 1-1, * page 1; figures 5-29 * | 1-15 | |

TECHNICAL FIELDS SEARCHED (IPC)

H03H

The present search report has been drawn up for all claims

| Place of search | Date of completion of the search | Examiner |
|---|---|---|
| Munich | 9 September 2021 | Naumann, Olaf |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 16 5912

This annex lists the patent family members relating to the patent documents cited in  the above-mentioned European search report.
The members are as contained in the European Patent Office EDP file on
The European Patent Office is in no way liable for these particulars which are merely given for the purpose of information.

09-09-2021

| Patent document cited in search report | Publication date | Patent family member(s) | Publication date |
|---|---|---|---|
| US 2011276284 A1 | 10-11-2011 | CA 2747027 A1 | 24-06-2010 |
| | | CN 102301601 A | 28-12-2011 |
| | | EP 2359479 A1 | 24-08-2011 |
| | | ES 2555210 T3 | 29-12-2015 |
| | | JP 5215477 B2 | 19-06-2013 |
| | | JP 2012512551 A | 31-05-2012 |
| | | KR 20110104021 A | 21-09-2011 |
| | | US 2011276284 A1 | 10-11-2011 |
| | | WO 2010069365 A1 | 24-06-2010 |

EPO FORM P0459

For more details about this annex : see Official Journal of the European Patent Office, No. 12/82